# EUROPEAN PATENT APPLICATION

(11) **EP 0 951 065 A2**
(43) Date of publication of application: **20.10.1999**
(21) Application number: 99107589.6
(22) Date of filing: 15.04.1999
(51) Int. Cl.: H01L 21/60, H01L 21/311

(54) **Method of manufacturing semiconductor device**

(30) Priority: 16.04.1998 JP 10615998
(71) Applicant: NEC CORPORATION, Tokyo (JP)
(72) Inventor: Kodama, Shuichi, Minato-ku, Tokyo (JP)
(74) Representative: Glawe, Delfs, Moll & Partner

(57) **Abstract**

In a method of manufacturing a semiconductor device, a passivation film is formed on a metal wiring layer on a semiconductor substrate. A first opening is formed in a predetermined region of the passivation film to reach a surface of the metal wiring layer. A dummy substrate made of silicon oxide sputter-etched in a process chamber of a plasma processing apparatus by using an inert gas plasma. In the process chamber of the plasma processing apparatus where sputter etching has been performed, the surface of the metal wiring layer exposed to a bottom portion of the first opening is sputter-cleaned by using an inert gas plasma.

## Description

### Background of the Invention

The present invention relates to a method of manufacturing a semiconductor device using an organic film.

In an LSI (Large Scale Integrated Circuit) package, when many pins are to be formed along its peripheral portion, the pin interval must be inevitably decreased. When the pin interval is set constant, an increase in the number of pins undesirably increases the package size. If terminals are formed over the whole surface of the package, many pins can be formed without increasing the package size.

As an example of forming terminals over the whole surface of the package, flip chip bonding is available by which a chip is connected to face a substrate where its active element surface is to be mounted. Usually, solder bumps are formed on the active element surface of the chip. The chip is turned over and positioned on the substrate where it is to be mounted. After that, the solder is melted to connect the chip at once.

Each solder bump used for this flip chip bonding is connected to an Al wiring pattern (metal wiring layer) through an opening in a passivation film serving as a protection film formed on the active element surface of the chip. Accordingly, in forming the solder bump, an opening for exposing the wiring pattern must be formed in the passivation film formed on the uppermost layer of the chip. To form the opening, dry etching is generally used. Since a resin such as polyimide is generally used to form the passivation film, oxygen is mainly used as an etching gas for dry etching.

As a mask pattern for this pattern formation is also made of an organic resin, when dry etching is performed by using oxygen gas, the mask pattern formed of a resist is also etched simultaneously as well as an opening formation portion of the passivation film made of polyimide. Therefore, in dry etching using oxygen gas, organic substances decomposed and sublimated by etching recombine to be readily deposited at various portions.

Even in dry etching not using oxygen, for example, even when carbon compound gas is used as an etching gas and an organic film is used as a mask pattern, the mask pattern is etched more or less. As a result, the decomposed and sublimated organic substances react with the etching gas, and the generated organic substances are deposited at various portions.

When such a deposit is deposited on the surface of the metal wiring layer exposed to the bottom portion of the opening, a thin film is readily formed to cause connection failure between the metal wiring layer and the solder bump formed on it.

In order to solve this problem, when forming an opening in the passivation film to expose a lower metal wiring layer, an inert gas plasma such as argon irradiates (sputter cleaning) the exposed metal wiring layer portion, thereby removing the material deposited in a region where the metal wiring layer is exposed. Sputter cleaning using this argon gas plasma process utilizes a sputtering phenomenon, and is effective also for removing native oxide formed on the exposed region of the metal wiring layer.

In sputter cleaning using this argon plasma, the cleaning target becomes the sputtering target, and a new problem arises in which the material that forms the target undesirably attaches to the inner wall of the plasma process chamber. In particular, when a passivation film or the like made of an organic substance is sputtered, a deposit composed of this organic substance is deposited on the inner wall of the process chamber. When such a deposit grows large, it forms organic substance dust, which then peels and falls to attach to the processing target, degrading the product yield. As such organic substance dust, one having a particle diameter of 0.2 µm or more is detected. When, for example, organic substance dust attaches to the surface of the metal wiring layer where a solder bump is to be formed, contact failure between the metal wiring layer and the solder bump occurs and the adhesion strength of the solder bump degrades.

### Summary of the Invention

It is an object of the present invention to provide a method of manufacturing a semiconductor device in which generation of dust in a processing apparatus is suppressed during sputter cleaning.

In order to achieve the above object, according to the present invention, there is provided a method of manufacturing a semiconductor device, comprising the steps of forming an organic insulting film on a wiring layer on a substrate, forming a first opening in a predetermined region of the organic insulating film to reach a surface of the wiring layer, sputter-etching a dummy substrate made of silicon oxide in a process chamber of a plasma processing apparatus by using an inert gas plasma, and sputter-cleaning, in the process chamber of the plasma processing apparatus where sputter etching has been performed, the surface of the wiring layer exposed to a bottom portion of the first opening by using an inert gas plasma.

### Brief Description of the Drawings

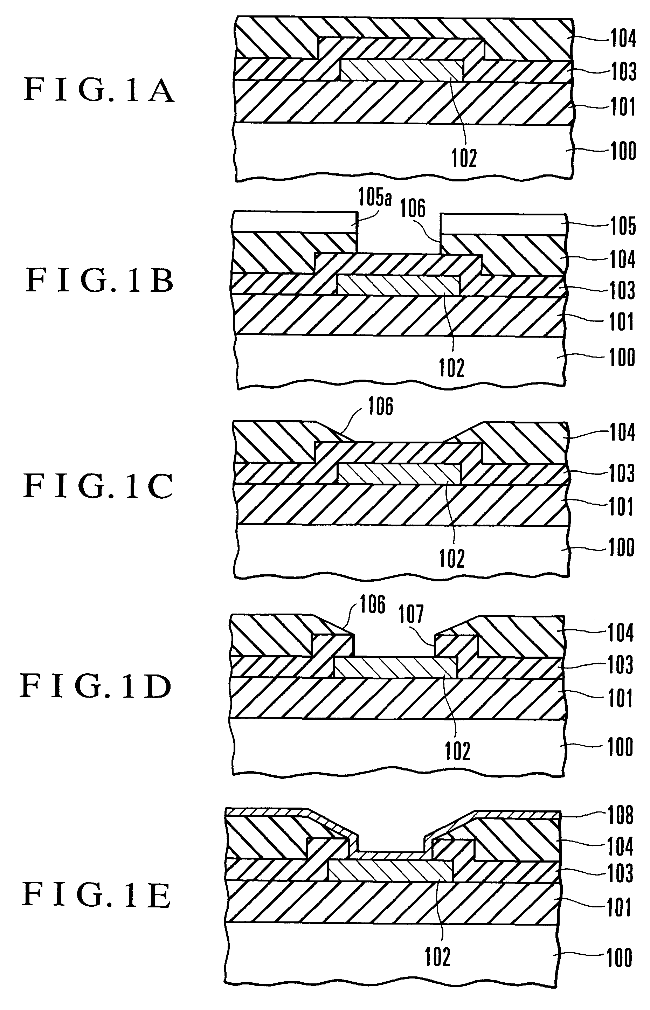

Figs. 1A to 1H are views showing the steps in manufacturing a semiconductor device according to one embodiment of the present invention.

### Description of the Preferred Embodiments

The present invention will be described in detail with reference to the accompanying drawings.

Figs. 1A to 1H show the steps in manufacturing a semiconductor device according to an embodiment of the present invention. As shown in Fig. 1A, an interlevel insulating film 101 made of silicon oxide is formed on a semiconductor substrate 100 on which elements such as transistors and a multilevel interconnection structure for connecting these elements are formed. In Fig. 1A, the elements and a multilevel interconnection that forms the multilevel interconnection structure, which are formed on the semiconductor substrate 100, are not illustrated.

An uppermost metal wiring layer 102 made of aluminum is formed on the interlevel insulating film 101. A cover film 103 made of silicon oxide is formed to cover the metal wiring layer 102, and thereafter a passivation film 104 serving as a protection film and made of polyimide is formed on the cover film 103.

In an LSI chip fabricated in this manner, as shown in Fig. 1B, a resist pattern 105 having an opening 105a is formed on the passivation film 104 on the metal wiring layer 102, and the passivation film 104 is selectively etched by using the resist pattern 105 as a mask. The resist pattern 105 is formed in accordance with known photolithography. Since this etching aims at etching polyimide as an organic substance, it is done by reactive ion etching using oxygen gas as an etching gas. As a result, an opening 106 is formed in a predetermined region of the passivation film 104 above the metal wiring layer 102.

When photosensitive polyimide is used as the material of the passivation film 104, the opening 106 is formed by patterning it in accordance with photolithography. In this case, photosensitive polyimide is applied to the cover film 103, and the resultant structure is then heated to remove the solvent. Exposure and development of a predetermined pattern are performed to form the opening 106. Then, the resultant structure is heated to thermoset the polyimide film where the opening is formed.

The resist pattern 105 is removed, and the resultant structure is heated to soften the passivation film 104, so that a moderate tilt surface is formed on the side surface of the opening 106, as shown in Fig. 1C.

As shown in Fig. 1D, the cover film 103 is selectively etched by using the passivation film 104 formed with the opening 106 as a mask, to form an opening 107 to reach the metal wiring layer 102. This etching is performed by reactive ion etching using CF₄ as an etching gas.

As shown in Fig. 1E, TiW composed of titanium and tungsten is deposited on the surface of the metal wiring layer 102 exposed to the bottom portion of the opening 107, the side surface of the opening 106, the side surface of the opening 107, and the surface of the passivation film 104 by sputtering, to form a TiW film 108.

At this time, while the semiconductor substrate 100 is anode-connected, sputter cleaning using an argon gas (inert gas) plasma is performed immediately before film formation by sputtering. When sputter cleaning is complete, the TiW film 108 is formed without exposing the semiconductor substrate 100 to the atmosphere.

In this sputter cleaning, the semiconductor substrate 100 is placed in the process chamber of the plasma processing apparatus, and the surface of the metal wiring layer 102 exposed to the bottom portion of the opening 107 is exposed to the argon gas plasma. In this state, argon gas ions impinge to remove the organic film deposited on the surface of the metal wiring layer 102 exposed to the bottom portion of the opening 107, and the formed native oxide.

Prior to sputter cleaning of the semiconductor substrate 100, a pre-process of sputter-cleaning a dummy substrate made of silicon oxide with the same plasma processing apparatus is performed. In other words, the dummy substrate is sputter-cleaned, and thereafter the surface of the metal wiring layer 102 exposed to the bottom surface of the opening 107 is sputter-cleaned.

In sputter-cleaning the dummy substrate made of silicon oxide, the dummy substrate, i.e., silicon oxide is sputter-etched. The sputter-etched silicon oxide is deposited on the inner wall of the plasma process chamber or the surfaces of other structures to form a silicon oxide film on their surfaces.

In the pre-process using the dummy substrate, the flow rate of the argon gas is set to 30 sccm, the RF power to be applied is set to 300 W, and the vacuum degree in the process chamber is set to 2 mTorr. The etching amount of silicon oxide is set to about 10 nm to 50 nm in the film thickness amount of the dummy substrate.

When a silicon oxide film is formed in this manner, the foreign substance attaching to the inner wall of the plasma process chamber or the surfaces of other structures is covered with the silicon oxide film. As a result, in sputter cleaning to be performed next for the surface of the metal wiring layer 102 exposed to the bottom portion of the opening 107, the foreign substance attaching to the inner wall of the plasma process chamber or the surfaces of other structures is prevented from peeling. In other words, when sputter-cleaning the surface of the metal wiring layer 102 exposed to the bottom portion of the opening 107, no foreign substance is generated in the plasma process chamber. As a result, a problem in which a foreign substance attaches to the surface of the sputter-cleaned metal wiring layer 102 can be prevented.

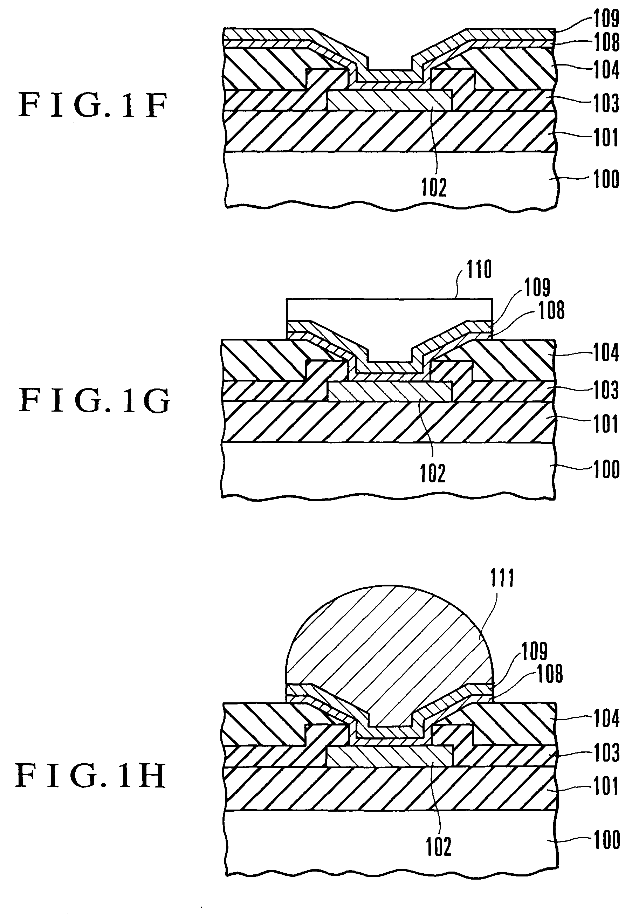

The TiW film 108 is formed after the pre-process and sputter cleaning described above are performed. Subsequently, Cu is deposited by sputtering to form a Cu film 109 on the TiW film 108, as shown in Fig. 1F. The Cu film 109 may be formed by plating in place of sputtering.

As shown in Fig. 1G, a resist pattern 110 is formed to cover the opening 107 and its peripheral region. The Cu film 109 and TiW film 108 are selectively etched by using the resist pattern 110 as a mask.

The resist pattern 110 is removed. After that, as shown in Fig. 1H, a solder bump 111 for flip chip bonding is formed on the Cu film 109.

The pre-process described above need not be performed for every substrate as a product. Table 1 shows the relationship among the number of processing target substrates processed by sputter cleaning, the number of dust particles detected on the substrates when the pre-processed is performed, and the number of dust particles detected on the substrates when the pre-processed is not performed.

**Table 1**

| | | | | | |
|---|---|---|---|---|---|
| Number of processed | 0 | 50 | 100 | 150 | 200 |
| substrates Number of dust particles without pre-process | 8 | 50 | 2000 | 5150 | 5400 |
| Number of dust particles with pre-process | 8 | 15 | 19 | 17 | 19 |

In Table 1, "the number of dust particles with pre-process" is the number of dust particles detected when the pre-process is performed for every 50 substrates. As is apparent from Table 1, without the pre-process, dust increases sharply when the number of substrates processed by sputter cleaning is about 100. Accordingly, the pre-process may be performed for every 100 substrates at minimum. As is apparent from Table 1, when the pre-process is performed, generation of dust can be suppressed greatly.

In the above embodiment, polyimide is used to form the passivation film. However, the present invention is not limited to this. The present invention can be applied to the manufacture of semiconductor devices using other organic films, e.g., to formation of a semiconductor device which uses a fluoroplastic or fluorinated plastic such as fluorinated polyarylether or fluorinated polyimide and in which a pattern including an opening is formed in a passivation film made of such a material.

As has been described above, according to the present invention, prior to the step of sputter-cleaning the metal wiring layer exposed to the bottom portion of the opening, the dummy substrate is sputter-etched, so that a thin silicon oxide film is formed on the inner wall of the plasma processing apparatus or the surfaces of structures. Therefore, the foreign substance attaching to the inner wall of the plasma processing apparatus or the surfaces of the structures can be covered with the thin silicon oxide film. As a result, the foreign substance attaching to the inner wall of the plasma processing apparatus or the like can be prevented from peeling and attaching to the substrate surface.

## Claims

1. A method of manufacturing a semiconductor device, characterized by comprising the steps of:
forming an organic insulting film (104) on a wiring layer (102) on a substrate (100);
forming a first opening (106) in a predetermined region of the organic insulating film to reach a surface of the wiring layer;
sputter-etching a dummy substrate made of silicon oxide in a process chamber of a plasma processing apparatus by using an inert gas plasma; and
sputter-cleaning, in said process chamber of said plasma processing apparatus where sputter etching has been performed, the surface of the wiring layer exposed to a bottom portion of the first opening by using an inert gas plasma.

2. A method according to claim 1, wherein
said method further comprises the step of forming an inorganic insulating film (103) between the organic insulating film and a surface of the substrate including the wiring layer, and
the step of forming the first opening comprises the step of selectively etching the inorganic insulating film by using as a mask the organic insulating film formed with the first opening, thereby forming a second opening (107) to reach the surface of the wiring layer.

3. A method according to claim 1, further comprising the steps of
forming, after sputter cleaning, a TiW film (108) made of titanium and tungsten on the surface of the exposed wiring layer, a side wall of the first opening, and on the organic insulating film around the first opening without exposure to an atmosphere,
forming a Cu film (109) on the TiW film; and
forming a solder bump (111) on the Cu film.

4. A method according to claim 1, wherein
the organic insulating film is made of polyimide, and
the inert gas is argon gas.

5. A method according to claim 4, wherein
a flow rate of the argon gas, an RF power to be applied, and a vacuum degree in said plasma chamber of said plasma processing apparatus are set to 30 sccm, 300 W, and 2 mTorr, respectively.

6. A method according to claim 1, wherein silicon oxide as a material of the dummy substrate is etched in an amount corresponding to 10 nm to 50 nm in a thickness of the dummy substrate.

7. A method according to claim 1, wherein the dummy substrate is sputter-etched every time a predetermined number of substrates are processed.
